# DEMANDE DE BREVET EUROPEEN

(11) **EP 4 006 730 A1**
(43) Date de publication de la demande: **01.06.2022**
(21) Numéro de dépôt: 21206831.6
(22) Date de dépôt: 08.11.2021
(51) Int. Cl.: G06F 9/52

(54) **PROCÉDÉ DE SIMULATION PARALLÈLE REPRODUCTIBLE DE NIVEAU SYSTÈME ÉLECTRONIQUE MIS EN OEUVRE AU MOYEN D'UN SYSTÈME INFORMATIQUE MULTI-COEURS DE SIMULATION À ÉVÈNEMENTS DISCRETS**

(30) Priorité: 25.11.2020 FR 2012150
(71) Demandeur: Commissariat à l'Énergie Atomique et aux Énergies Alternatives, 75015 Paris (FR); Centre National de la Recherche Scientifique - CNRS, 75016 Paris (FR); Université Claude Bernard Lyon I, 69622 Villeurbanne Cedex (FR); ENS - Ecole Normale Supérieure de Lyon, 69007 Lyon (FR)
(72) Inventeur: MOY, Matthieu, 69009 Lyon (FR); SASSOLAS, Tanguy, 01191 Gif-sur-Yvette (FR)
(74) Mandataire: Marks & Clerk France

(57) **Abrégé**

Procédé de simulation a événements discrets parallèle reproductible de niveau système électronique mis en oeuvre au moyen d'un système informatique multi-coeurs, ledit procédé de simulation comprenant une succession de phases d'évaluation, mises en oeuvre par un noyau de simulation exécuté par ledit système informatique, comprenant les étapes suivantes :
- ordonnancement parallèle de processus (1) ;
- detection dynamique d'adresses partagées (2);
- évitement de conflits d'accès (3) a des adresses de la mémoire partagée;
- verification de conflits d'accès (4) a des adresses de mémoire partagée;
- retour en arrière (5), lors d'une detection d'au moins un conflit ; et
- génération d'une trace d'execution (6) permettant la reproduction ultérieure de la simulation a l'identique.

## Description

L'invention porte sur un procédé de simulation parallèle reproductible de niveau système électronique mis en œuvre au moyen d'un système informatique multi-cœurs de simulation à événements discrets.

L'invention concerne le domaine des outils et méthodologies de conception des systèmes sur puce, et vise à augmenter la vitesse d'exécution des outils de prototypage virtuel afin d'accélérer les premières phases de conception des systèmes sur puce.

Un système sur puce peut être décomposé en deux composantes : le matériel et le logiciel. Le logiciel, qui représente une part croissante des efforts de développement des systèmes sur puce, doit être validé au plus tôt. En particulier, il n'est pas possible d'attendre la fabrication du premier prototype matériel pour des raisons de coût et de délais de mise sur le marché. Pour répondre à ce besoin, des outils de modélisation de haut niveau ont été mis au point. Ces outils permettent la description d'un prototype virtuel haut-niveau de la plateforme matérielle. Le logiciel destiné au système en cours de conception peut alors être exécuté et validé sur ce prototype virtuel.

La complexité des systèmes sur puce modernes rend par ailleurs leur optimisation complexe. Les choix architecturaux les plus adaptés à la fonction du système et au logiciel associé sont multicritères et difficiles à optimiser au-delà d'un certain point. Le recours aux prototypes virtuels permet alors d'effectuer de l'exploration architecturale rapide. Cela consiste à mesurer les performances (e.g. vitesse, consommation énergétique, température) d'une variété de configuration différentes (e.g. taille mémoire, configuration de cache, nombre de cœurs) afin de choisir celle présentant le meilleur compromis. La qualité des résultats fournis par la phase d'exploration initiale impactera grandement la qualité et la compétitivité du produit final. La rapidité et la fiabilité des outils de simulation est donc un enjeu crucial.

La majorité de ces outils sont basés sur la bibliothèque C++ de description matérielle SystemC/TLM2.0 [SYSC, TLM] décrite dans le standard IEEE 1666^{™}-2011.

SystemC est un langage de description de matériel permettant la réalisation de prototypes virtuels de systèmes numériques. Ces prototypes virtuels peuvent alors être simulés à l'aide d'un simulateur à événements discrets. Le standard SystemC indique que ce simulateur doit respecter la sémantique de coroutine, i.e. que les processus concurrents simulés d'un modèle sont exécutés séquentiellement. Cela limite l'exploitation des ressources de calcul disponibles sur une machine à un unique cœur à la fois.

L'invention propose un noyau de simulation SystemC parallèle supportant tous types de modèles (comme RTL pour acronyme de "Register Transfer Level" en langue anglaise et TLM pour acronyme de "Transactional Level Modeling" en langue anglaise).

SystemC est utilisé comme support explicatif de la présente description car celle-ci s'applique avantageusement au prototypage virtuel, mais tout système de simulation à événement discrets appliqué aux systèmes électroniques est susceptible de bénéficier de l'invention décrite, tels que Verilog ou VHDL.

La parallélisation de SystemC a fait l'objet de plusieurs approches applicables à différentes familles de modèles comme suivent.

Une première technique vise à empêcher les erreurs liées à la parallélisation par le biais d'une analyse statique de code tel que dans [SCHM18]. Un compilateur spécialisé pour les programmes SystemC permet d'analyser le code source d'un modèle. Il se concentre sur les transitions, c'est-à-dire les portions de code exécutées entre deux appels à la primitive de synchronisation "wait()". Ces portions devant être évaluées de manière atomique, le compilateur scrute les éventuelles dépendances entre ces transitions afin de déterminer si elles peuvent être évaluées en parallèle. Cette technique raffine l'analyse en distinguant les modules et les ports afin de limiter les détections de faux positifs. Un ordonnancement statique des processus peut alors être calculé. Cependant, dans le contexte d'un modèle TLM, tous les processus accédant par exemple à une même mémoire seront ordonnancés de manière séquentielle, rendant cette approche inefficace.

Une autre approche rencontrée dans [SCHU10] consiste à exécuter en parallèle tous les processus d'un même delta cycle. Cette famille de techniques vise généralement la modélisation au niveau RTL. Afin de rester conforme au standard SystemC et d'éviter les erreurs de simulations dues aux ressources partagées, il revient au développeur du modèle de protéger ces dernières. Par ailleurs, en cas d'accès multiples à une ressource partagée de la part de plusieurs processus, l'ordre des accès n'est pas contrôlé, ce qui compromet la reproductibilité de la simulation.

Afin de mieux supporter la simulation de modèles TLM, [MELL10, WEIN16] recourent au découplage temporel. Cela consiste à diviser le modèle en un ensemble de groupes de processus temporellement indépendants. Ces techniques appliquent les principes de la simulation parallèle à événements discrets. Elles consistent à autoriser différents processus à évoluer à des dates différentes tout en garantissant que ces derniers ne reçoivent jamais d'événements déclenchés à des dates passées. [MELL10] recours à l'envoi de messages datés pour synchroniser les processus et [WEIN16] introduit des délais de communication entre deux groupes de processus, permettant ainsi à l'un de prendre une avance au plus égale au délai du canal de communication sans risque de manquer un message. Ces approches contraignent cependant à l'utilisation de canaux de communication spécifiques entre deux groupes de processus et sont plus adaptés à des modèles TLM de bas niveau dits à temps approximé ("approximately-timed" en langue anglaise). Les modèles dits à temps proche ("loosely-timed" en langue anglaise) recourent à des techniques de simulation haut niveau telles que l'accès direct à la mémoire (DMI pour acronyme de "Direct Memory Interface" en langue anglaise) sont souvent incompatibles avec ces méthodes.

Des zones de processus sont également utilisées dans [SCHU13]. On appelle zone de processus l'ensemble des processus et des ressources associées pouvant être accédées par ces processus. Les processus d'une même zone sont exécutés séquentiellement, garantissant leur atomicité. Les processus de différentes zones sont quant à eux exécutés en parallèle. Afin de préserver l'atomicité, lorsqu'un processus d'une zone tente d'accéder à des ressources appartenant à une autre zone (variables ou fonctions appartenant à un module situé dans une autre zone), il est interrompu, son contexte est migré vers la zone visée puis il est relancé séquentiellement par rapport aux autres processus de sa nouvelle zone. Cette technique ne garantit cependant pas l'atomicité de processus dans tous les cas. Si, par exemple, un processus *Pₐ* modifie un état *Sₐ* de la même zone avant de changer de zone pour modifier un état *S_{b}*. Pendant ce temps, un processus *P_{b}* modifiait *S_{b}* avant de changer de zone pour modifier *Sₐ*. À ce stade, chaque processus verra les modifications apportées par l'autre processus au cours de la phase d'évaluation courante, violant l'atomicité d'évaluation des processus. De plus, en présence d'une mémoire globale partagée, tous les processus seraient séquentialisés lors de l'accès à cette mémoire, présentant ainsi des performances proches d'une simulation entièrement séquentielle.

Dans [MOY13], il est possible de spécifier la durée d'une tâche et de l'exécuter de manière asynchrone dans un thread système dédié. Ainsi, deux tâches se recouvrant dans le temps peuvent s'exécuter simultanément. Cette approche fonctionne mieux pour les processus longs et indépendants. Cependant, l'atomicité des processus n'est plus garantie s'ils interagissent entre eux au cours de leur exécution comme par exemple en accédant à une même mémoire partagée.

Dans la solution proposée dans [VENT16], l'ensemble des processus d'un même delta cycle sont exécutés en parallèle. Afin de préserver l'atomicité d'évaluation des processus, [VENT16] repose sur l'instrumentation des accès mémoire. Chaque accès mémoire doit ainsi être accompagné d'un appel à une fonction d'instrumentation qui vérifiera si l'accès concerne une adresse préalablement déclarée partagée par l'utilisateur. Dans ce cas, seul le premier processus à accéder à une des adresses partagées est autorisé à poursuivre lors de l'évaluation parallèle des processus. Les autres doivent poursuivre leur exécution lors d'une phase séquentielle. Des graphes de dépendance entre accès mémoire sont également construits lors de l'instrumentation des accès mémoire. À l'issue de chaque phase d'évaluation, ces graphes sont analysés afin de vérifier que tous les processus ont bien été évalués de manière atomique. Dans le cas contraire, l'utilisateur a oublié de déclarer certaines adresses partagées.

Une approche visant un problème similaire est proposée dans [LE14]. L'objectif y est de vérifier la validité d'un modèle en montrant que pour une entrée donnée, tous les ordonnancements de processus possibles donnent la même sortie. Afin de vérifier cela, il est vérifié formellement que tous les ordonnancements possibles donnent la même sortie. Un modèle C statique est généré à partir du modèle C++ pour cela. Cette approche entend cependant par déterminisme le fait que les processus sont indépendants à l'ordonnancement. Cette supposition s'avère fausse pour des modèles de plus hauts niveau tels que les modèles TLM dans lesquels les interactions ont lieu lors de la phase d'évaluation et non pas lors de la phase de mise à jour. Une telle vérification formelle serait de toute manière impossible pour un système complexe et ne s'applique qu'à des IP de faible dimension.

Enfin, [JUNG19] propose d'effectuer du découplage temporel spéculatif à l'aide de l'appel system Linux "fork(2)". La fonction fork(2) permet la duplication d'un processus. Le découplage temporel se réfère ici à une technique utilisée en modélisation TLM appelée "loosely-timed", qui consiste à autoriser un processus à prendre de l'avance sur le temps global de la simulation et de ne synchroniser qu'à intervalles de temps d'une durée constante appelée quantum. Cela accélère grandement la vitesse de simulation mais introduit des erreurs temporelles. Par exemple, un processus peut recevoir à la date locale *t*₀ un événement envoyé par un autre processus dont la date locale était *t*₁ avec *t*₁ < *t*₀, violant le principe de causalité. Afin d'améliorer la précision de ces modèles utilisant le découplage temporel, [JUNG19] implémente une technique de retour en arrière basée sur fork(2). Afin de sauvegarder l'état de la simulation, celle-ci est dupliquée à l'aide d'un appel à fork(2). L'une des deux versions de la simulation s'exécutera ensuite avec un quantum de retard sur l'autre. En cas d'erreur de timing lors d'un quantum, la version en retard pourra alors forcer les synchronisations lorsqu'elle atteindra ce quantum et ainsi éviter l'erreur.

[JUNG19] utilise le retour en arrière au niveau processus pour corriger des erreurs de timing de simulation. Cependant, la vitesse de simulation est toujours limitée par les performances mono-cœur de la machine hôte. Dans le contexte d'une simulation parallèle, fork(2) ne permet plus de sauvegarder l'état de la simulation car les threads ne sont pas dupliqués par fork(2) rendant cette approche inapplicable dans le cas de l'invention. De plus, le fait de corriger les erreurs de timing d'un modèle utilisant les quantums constitue, au sens strict, une violation d'atomicité des processus, ces derniers étant interrompus par le noyau de simulation sans appel à la primitive wait(). Cette fonctionnalité peut être voulue par certains mais est incompatible avec la volonté de respecter le standard SystemC.

[VENT16] utilise un procédé dans lequel les processus concurrents d'une simulation SystemC sont exécutés dans des files d'exécution parallèles associées chacun à un cœur logique spécifique de la machine hôte. Un procédé d'analyse de dépendances entre les processus est mis en place afin de garantir leur atomicité. [VENT16] repose sur la déclaration manuelle de zones mémoires partagées pour garantir une simulation valide. Il est cependant souvent impossible de connaître ces zones a priori en cas d'allocation dynamique de mémoire ou de mémoire virtualisée comme souvent sous un système d'exploitation. [VENT16] recourt à une phase parallèle et une phase séquentielle optionnelle en cas de processus préemptés pour accès interdit à une mémoire partagée lors de la phase parallèle. Tout parallélisme est empêché lors de cette phase séquentielle et provoque un important ralentissement.

[VENT16] procède à l'établissement de dépendances au travers de multiples graphes construits au cours de la phase d'évaluation. Cela requiert des mécanismes de synchronisation lourds qui ralentissent fortement la simulation pour garantir l'intégrité des graphes. [VENT16] requiert de surcroît que le graphe de dépendances global soit complété et analysé à l'issue de chaque phase parallèle, ralentissant davantage la simulation. [VENT16] manipule les files d'exécution de manière monolithique, c'est-à-dire que si un processus de la simulation est séquentialisé, tous les processus de la même file d'exécution seront séquentialisés aussi.

[VENT16] propose de reproduire une simulation à partir d'une linéarisation du graphe de dépendances de chaque phase d'évaluation stocké dans une trace. Cela contraint à évaluer séquentiellement des processus qui peuvent s'avérer indépendants comme pour le graphe (1→2, 1→3) qui serait linéarisé en (1, 2, 3) alors que 2 et 3, ne dépendant pas l'un de l'autre, peuvent être exécutés en parallèle.

Un but de l'invention est de pallier les problèmes précédemment cités, et notamment d'accélérer la simulation tout en la gardant reproductible tout en améliorant la performance dans des contextes de très fortes interactions.

Il est proposé, selon un aspect de l'invention, un procédé de simulation à événements discrets parallèle reproductible de niveau système électronique mis en œuvre au moyen d'un système informatique multi-cœurs, ledit procédé de simulation comprenant une succession de phases d'évaluation, mises en œuvre par un noyau de simulation exécuté par ledit système informatique, comprenant les étapes suivantes :
- ordonnancement parallèle de processus ;
- détection dynamique d'adresses partagées d'au moins une mémoire partagée d'un système électronique simulé par des processus concurrents, à des adresses de la mémoire partagée, utilisant une machine à états, respectivement associée à chaque adresse de la mémoire partagée ;
- évitement de conflits d'accès à des adresses de la mémoire partagée par des processus concurrents, par préemption d'un processus par le noyau lorsque ledit processus introduit une dépendance inter-processus de type "lecture après écriture" ou "écriture après lecture ou écriture" ou lorsque le processus simule un processeur dont le niveau de privilège passe du niveau inférieur à un niveau supérieur ;
- vérification de conflits d'accès à des adresses de mémoire partagée par analyse des dépendances inter-processus utilisant une trace des accès aux adresses de mémoire partagée de chaque phase d'évaluation et une recherche de cycles dans un graphe de dépendances inter-processus ;
- retour en arrière, lors d'une détection d'au moins un conflit, pour rétablir un état passé de la simulation après détermination d'un ordre d'exécution sans conflit des processus de la phase d'évaluation conflictuelle durant laquelle est détectée le conflit, lors d'une nouvelle simulation identique jusqu'à la phase d'évaluation conflictuelle exclue ; et
- génération d'une trace d'exécution permettant la reproduction ultérieure de la simulation à l'identique.

Un tel procédé permet la simulation parallèle de modèles SystemC dans le respect du standard. En particulier, ce procédé autorise la reproduction à l'identique d'une simulation, facilitant le débogage. Il supporte des modèles de simulation de type « loosely-timed » TLM utilisant le découplage temporel par l'utilisation d'un quantum de simulation et les accès directs à la mémoire (DMI), très utiles pour atteindre des vitesses de simulation élevées. Enfin, il permet de détecter de façon autonome et dynamique les adresses partagées et supporte donc l'utilisation de mémoires virtuelles, indispensable pour l'exécution de systèmes d'exploitation.

Selon un mode de mise en œuvre, l'ordonnancement parallèle de processus utilise des files d'au moins un processus, les processus d'une même file étant exécutés séquentiellement par une tâche système associée à un cœur logique.

Ainsi, les processus placés dans des files différentes sont exécutés en parallèle. Les files de processus pouvant être peuplées manuellement ou automatiquement, il est par exemple possible de rassembler les processus risquant de présenter des dépendances ou de rééquilibrer la charge de chaque cœur en migrant des processus d'une file à l'autre.

Dans un mode de réalisation la reprise de l'exécution d'une file d'au moins un processus, dont l'exécution a été suspendue suite à la préemption d'un de ses processus par le noyau, est effectuée dans une sous-phase parallèle ultérieure si la préemption est due à l'introduction par ledit processus d'une dépendance inter-processus de type "lecture après écriture" ou "écriture après lecture ou écriture", ou est effectuée dans une sous-phase séquentielle ultérieure si la préemption est due au passage du cœur logique exécutant le processus d'un niveau de privilège inférieur à un niveau de privilège supérieur.

Ainsi, Ainsi, il est assuré qu'aucune dépendance de type "lecture après écriture" ou "écriture après lecture ou écriture" ne pourra être introduite entre des accès mémoires effectués après passage du niveau de privilège des cœurs logiques effectuant ces accès d'un niveau inférieur à un niveau supérieur.

Dans un mode de mise en œuvre, le retour en arrière utilise des sauvegardes d'états de la simulation durant la simulation faites par le noyau de simulation.

Ainsi, il est possible de rétablir la simulation dans chacun des états sauvegardés et de la reprendre de ce point. Faites à intervalles réguliers, ces sauvegardes permettent de modérément pénaliser l'exécution lors d'un retour en arrière.

Selon un mode de mise en œuvre, la machine à états d'une adresse de la mémoire partagée comprend les quatre états suivants :
- "pas d'accès" (No_acces), lorsque la machine à états a été réinitialisée, sans file d'au moins un processus définie comme possesseur de l'adresse ;
- "possédée" (Owned) lorsque l'adresse a été accédée par une unique file d'au moins un processus dont une fois en écriture, ladite file étant alors définie comme possesseur de l'adresse ;
- "en lecture exclusive" (Read_exclusive) lorsque l'adresse a été accédée exclusivement en lecture par une unique file d'au moins un processus, ladite file étant alors définie comme possesseur de l'adresse ; et
- "en lecture partagée" (Read_shared) lorsque l'adresse a été accédée exclusivement en lecture par au moins deux files d'au moins un processus, sans file définie comme possesseur de l'adresse.

Ainsi, il est possible de classer simplement les adresses selon les accès qui y ont été effectués. L'état d'une adresse déterminera ensuite les accès y étant autorisés et cela via une empreinte mémoire minimale.

Dans un mode de mise en œuvre, la préemption d'un processus par le noyau est déterminée lorsque :
- un accès en écriture est demandé sur une adresse de la mémoire partagée par une file d'au moins un processus qui n'est pas possesseur dans la machine à états de l'adresse, et l'état courant est différent de "pas d'accès" ; ou
- un accès en lecture est demandé sur une adresse de la mémoire partagée, dont la machine à états est dans l'état "possédée" ou " en lecture exclusive" par une file d'au moins un processus différente de la file possesseur de l'adresse dans la machine à états de l'adresse.

Ainsi, aucune dépendance entre files d'au moins un processus ne peut être introduite au cours d'une sous-phase d'évaluation.

Selon un mode de mise en œuvre, toutes les machines à états des adresses de la mémoire partagée sont réinitialisées à l'état "pas d'accès " régulièrement.

Ainsi, il est préférable de maximiser le parallélisme en libérant les états des adresses observés dans des quantums précédents. En effet, l'avantage d'utiliser les quantums est de ne pas avoir à considérer l'historique d'accès à la mémoire depuis le début de l'exécution de la simulation. De plus, entre différents quantums une adresse peut être utilisée différemment et l'état lui correspondant le mieux peut changer.

Dans un mode de mise en œuvre, toutes les machines à états des adresses de la mémoire partagée sont réinitialisées à l'état "pas d'accès " lors de la phase d'évaluation suivant la préemption d'un processus.

Ainsi, la préemption d'un processus peut s'avérer caractéristique d'un changement d'utilisation d'une adresse dans le programme simulé, et il est préférable de maximiser le parallélisme en libérant les états des adresses observées dans des quantums précédents.

Selon un mode de mise en œuvre, la vérification de conflits d'accès à des adresses de mémoire partagée lors de chaque phase d'évaluation est effectuée de manière asynchrone, pendant l'exécution des phases d'évaluation ultérieures.

Ainsi, la vérification des conflits d'accès ne bloque pas l'avancement de la simulation. Ce procédé participe avantageusement à réduire le temps de simulation.

Dans un mode de mise en œuvre, la trace d'exécution permettant la reproduction ultérieure de la simulation à l'identique comprend une liste de numéros représentatifs de phases d'évaluation associés à un ordre partiel d'évaluation des processus définis par les relations de dépendances inter-processus de chaque phase d'évaluation.

Ainsi, il est possible de réexécuter la simulation à l'identique, facilitant le débogage de l'application et de la plateforme simulée.

Selon un mode de mise en œuvre, un retour en arrière, lors d'une détection d'au moins un conflit, rétablit un état passé de la simulation, puis reproduit la simulation à l'identique jusqu'à la phase d'évaluation ayant produit le conflit et exécute alors séquentiellement ses processus.

Ainsi, il est assuré que le conflit ayant nécessité un retour en arrière ne se reproduira plus. La simulation pourra alors poursuivre sa progression.

Dans un mode de mise en œuvre, un retour en arrière, lors d'une détection d'au moins un conflit, rétablit un état passé de la simulation, puis reproduit la simulation à l'identique jusqu'à la phase d'évaluation ayant produit le conflit et exécute alors ses processus d'après un ordre partiel déduit du graphe de dépendance de la phase d'évaluation ayant produit le conflit après en avoir supprimé un arc par cycle.

Ainsi, il est assuré que le conflit ayant nécessité un retour en arrière ne se reproduira plus. De plus, l'exécution partiellement parallèle de la phase d'évaluation conflictuelle présente une accélération face à une exécution séquentielle de cette même phase. La simulation pourra alors poursuivre sa progression.

Selon un mode de mise en œuvre, un état de la simulation est sauvegardé à intervalles réguliers de phases d'évaluation.

Ainsi, il est possible de rétablir la simulation dans un état antérieur relativement proche en cas de conflit. Il s'agit ici d'un compromis. Plus les intervalles sont petits et plus cela aura un impact sur les performances globales lors des sauvegardes, mais le surcoût d'un retour en arrière sera plus faible. Au contraire, plus les intervalles sont importants, et moins cela aura d'impact sur les temps de simulation, mais un retour en arrière sera plus coûteux.

Dans un mode de mise en œuvre, un état de la simulation est sauvegardé à intervalles de phases d'évaluation augmentant en l'absence de détection de conflit et en diminuant suite à détection de conflit.

Ainsi, il est possible de limiter le nombre de sauvegardes lors des phases de la simulation ne présentant pas de conflits, augmentant de la sorte les performances de simulation.

Il est également proposé, selon un autre aspect de l'invention, un produit programme d'ordinateur comprenant du code informatique exécutable par ordinateur, stocké sur un support lisible par ordinateur et adapté pour mettre en œuvre un procédé tel que précédemment décrit.

L'invention sera mieux comprise à l'étude de quelques modes de réalisation décrits à titre d'exemples nullement limitatifs et illustrés par les dessins annexés sur lesquels les figures :
[Fig.1] illustre schématiquement les phases d'une simulation SystemC, selon l'état de l'art ;
[Fig.2] illustre schématiquement un mode de mise en œuvre du procédé de simulation parallèle reproductible de niveau système électronique mis en œuvre au moyen d'un système informatique multi-cœurs de simulation à événements discrets, selon un aspect de l'invention ;
[Fig.3], illustre schématiquement, un ordonnancement parallèle de processus, selon un aspect de l'invention ;
[Fig.4] illustre schématiquement une machine à états associée à une adresse de mémoire partagée, selon un aspect de l'invention ;
[Fig.5] illustre schématiquement une structure de données permettant l'enregistrement d'une trace des accès mémoire effectués par chacune des files d'exécution de la simulation, selon un aspect de l'invention ;
[Fig.6] illustre schématiquement un algorithme permettant d'extraire un ordre partiel d'exécution de processus d'après un graphe de dépendances interprocessus, selon un aspect de l'invention ;
[Fig.7] illustre schématiquement la procédure de retour en arrière en cas de détection d'une erreur lors de la simulation, selon un aspect de l'invention ;
[Fig.8] illustre schématiquement une trace permettant la reproduction à l'identique d'une simulation, selon un aspect de l'invention ;
[Fig.9] illustre schématiquement un tableau de dépendance de processus, selon un aspect de l'invention, et
[Fig.10] illustre schématiquement un cas résolu par l'invention mais non résolu par l'état de l'art.

Sur l'ensemble des figures, les éléments ayant des références identiques sont similaires.

L'invention repose sur la surveillance ou "monitoring" en langue anglaise des accès mémoire associée à une méthode de détection des adresses partagées ainsi qu'à un système permettant de rétablir un état antérieur de la simulation et à un système de reproduction de simulation.

Pour répondre au besoin d'accélération des outils de prototypage virtuel, les techniques de modélisation s'appuient sur des abstractions de plus en plus haut niveau. Cela a permis de tirer parti du compromis entre vitesse et précision. En effet, un modèle moins détaillé requiert moins de calcul pour simuler une action donnée, augmentant le nombre d'actions simulables en un temps donné. Il devient cependant de plus en plus difficile d'élever le niveau d'abstraction des modèles sans compromettre la validité des résultats de simulation. Des résultats de simulation trop imprécis entrainant fatalement des erreurs de conception coûteuses en aval, il est important de maintenir un niveau de précision suffisant.

Face à la difficulté d'augmenter davantage le niveau d'abstraction des prototypes virtuels, la présente invention propose de recourir au parallélisme pour accélérer la simulation des systèmes sur puce. En particulier, on utilise une technique de simulation parallèle des modèles SystemC.

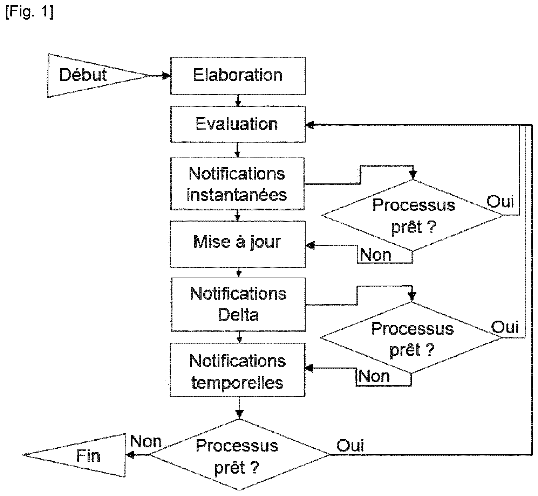

Une simulation SystemC se décompose en trois phases, comme illustrées sur la figure 1 : l'élaboration pendant laquelle les différents modules du modèle sont initialisés ; l'évaluation pendant laquelle le nouvel état du modèle est calculé d'après son état courant via l'exécution des différents processus du modèle ; et la mise à jour pendant laquelle les résultats de la phase d'évaluation sont propagés dans le modèle en vue de la prochaine phase d'évaluation.

Suite à l'élaboration effectuée en début de simulation, les phases d'évaluation et de mise à jour s'alternent jusqu'à la fin de la simulation selon le diagramme d'exécution de la figure 1. La phase d'évaluation est déclenchée par trois types de notifications : instantanées, deltas, et temporelles. Une notification instantanée a pour effet de programmer l'exécution de processus supplémentaires directement pendant la phase d'évaluation courante. Une notification delta programme l'exécution d'un processus dans une nouvelle phase d'évaluation se déroulant à la même date (temps de la simulation). Une notification temporelle, enfin, programme l'exécution d'un processus à une date ultérieure. C'est ce type de notification qui provoque l'avancement du temps simulé. La phase d'évaluation requiert significativement plus de temps de calcul que les deux autres. C'est donc l'accélération de cette phase qui procure le plus grand gain et qui fait l'objet de l'invention.

Afin de faciliter l'analyse et le débogage du modèle et du logiciel simulés, le standard SystemC réclame qu'une simulation soit reproductible, c'est-à-dire qu'elle produise toujours le même résultat d'une exécution à la suivante en présence des mêmes entrées. Il est pour cela imposé que les différents processus programmés pour s'exécuter lors d'une phase d'évaluation donnée soient exécutés dans le respect de la sémantique de coroutine et donc de manière atomique. Ceci permet d'obtenir un résultat de simulation identique entre deux exécutions avec les mêmes conditions d'entrée. L'atomicité est une propriété utilisée en programmation concurrente pour désigner une opération ou un ensemble d'opérations d'un programme qui s'exécutent entièrement sans pouvoir être interrompus avant la fin de leur déroulement et sans qu'un état intermédiaire de l'opération atomique ne puisse être observé.

Cette règle impose, a priori, l'utilisation d'un unique cœur sur la machine hôte de la simulation, ce qui limite grandement les performances atteignables sur les machines de calcul modernes disposant de nombreux cœurs. Or, seul le respect de la sémantique de coroutines est réllement essentiel : les processus doivent être exécutés de manière équivalente à une exécution séquentielle, c'est-à-dire de manière atomique, mais pas nécessairement séquentiellement en pratique. La contrainte suffisante de séquentialité figurant dans le standard peut ainsi être dégradée en une contrainte nécessaire d'atomicité : les processus doivent s'exécuter comme s'ils étaient seuls du début à la fin de leur exécution. Cela laisse des opportunités pour paralléliser la phase d'évaluation d'une simulation SystemC.

La principale cause de non atomicité des processus dans le cas d'une évaluation parallèle provient des interactions inter-processus. En effet, SystemC ne contraint pas les processus à ne communiquer qu'au travers des canaux, ou "channels" en langue anglaise, que fournit le langage (courant en modélisation RTL) et dont les entrées ne sont modifiées que lors de la phase de mise-à-jour, fournissant une forme d'isolation au cours de la phase d'évaluation. Au contraire, en modélisation TLM notamment, la phase de mise à jour, ou "update" en langue anglaise, revêt une importance moindre et les interactions ont principalement lieu lors de la phase d'évaluation.

A ces fins, toutes les fonctionnalités offertes par la langage C++ sont utilisables au sein d'un processus SystemC. En particulier, il est possible d'accéder et de modifier des zones de mémoire partagée sans protection particulière préalable. Si plusieurs processus accèdent à une même zone de mémoire simultanément, il est possible qu'ils lisent ou écrivent des valeurs impossibles dans le cas d'une exécution séquentielle stricte. C'est ce type d'interaction qui constitue le risque principal de non atomicité des processus et que l'invention traite spécifiquement. Les violations d'atomicité des processus sont nommées conflits dans la suite de la présente demande.

L'invention présente un mécanisme garantissant l'atomicité des processus qui ineragissent via mémoire partagée uniquement. Il est par ailleurs possible de reproduire une simulation passée à partir d'une trace stockée dans un fichier.

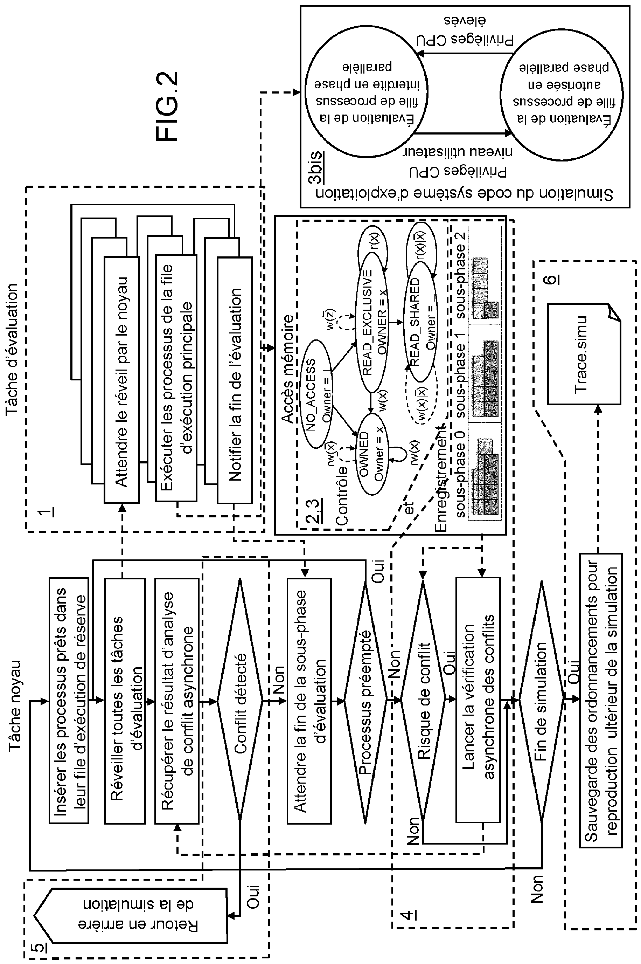

La figure 2 représente schématiquement six composantes distinctes en interaction de l'invention, permettant la simulation parallèle de modèles SystemC :
- ordonnancement parallèle 1 de processus, par exemple par files de processus, les processus d'une même file étant attribués à un même cœur logique. Bien entendu, en variante, l'ordonnancement parallèle peut aussi recourir à une répartition des processus par partage global, c'est-à-dire que chaque tâche d'évaluation exécute un processus en attente prélevé dans la file globale des processus devant être évalués au cours de la phase d'évaluation présente ;
- détection dynamique 2 d'adresses partagées d'au moins une mémoire partagée d'un système électronique simulé et d'évitement de conflits d'accès, par des processus concurrents, à des adresses de la mémoire partagée, par préemption de processus par le noyau, utilisant une machine à états, respectivement associée à chaque adresse de la mémoire partagée, déterminant une préemption d'un processus lorsqu'il introduit une dépendance interprocessus de type "lecture après écriture" ou "écriture après lecture ou écriture", sans nécessité de fournir au préalable des informations relatives à l'utilisation faite par le programme des différentes plages d'adresses ;
- évitement de conflits d'accès 3 à des adresses de la mémoire partagée par des processus concurrents, par préemption d'un processus par le noyau lorsque ledit processus introduit une dépendance inter-processus de type "lecture après écriture" ou "écriture après lecture ou écriture" ou lorsque le processus simule un processeur dont le niveau de privilège 3bis passe du niveau inférieur à un niveau supérieur;
- vérification de conflits d'accès 4 à des adresses de mémoire partagée par analyse des dépendances inter-processus utilisant une trace des accès aux adresses de mémoire partagée de chaque phase d'évaluation et une recherche de cycles dans un graphe de dépendances inter-processus ;
- retour en arrière 5, lors d'une détection d'au moins un conflit, pour rétablir un état passé de la simulation après détermination d'un ordre d'exécution des processus de la phase d'évaluation conflictuelle durant laquelle est détectée le conflit, déterminé à partir du graphe de dépendance interprocessus, pour éviter le conflit détecté dans une nouvelle simulation identique jusqu'à la phase d'évaluation conflictuelle exclue ; et
- génération d'une trace d'exécution 6 permettant la reproduction ultérieure de la simulation à l'identique.

L'ordonnancement parallèle permet d'exécuter en parallèle des processus concurrents d'une simulation, par exemple par file d'exécution, auquel cas chaque file d'exécution est attribuée à un cœur logique de la machine hôte. Une phase d'évaluation se compose alors d'une succession de sous-phases parallèles dont le nombre dépend de l'existence de processus préemptés au cours de chaque sous-phase d'évaluation. L'exécution parallèle des processus nécessite des précautions pour préserver leur atomicité. Pour ce faire, les accès mémoire, qui représentent la forme d'interaction la plus fréquente, sont instrumentés.

Lors de l'exécution des différents processus de la simulation, chaque accès mémoire doit être instrumenté par un appel préalable à une fonction spécifique. La fonction d'instrumentation déterminera les dépendances interprocessus éventuelles engendrées par l'action instrumentée. Le cas échéant, le processus à l'origine de l'action peut être préempté. Il reprend alors son exécution aux côtés des autres processus préemptés dans une nouvelle sous-phase d'évaluation parallèle. Ces sous-phases d'évaluation parallèle s'enchaînent alors jusqu'à ce que tous les processus soient intégralement évalués.

Afin de gérer les interactions par accès à une mémoire partagée, à chaque adresse est associée une machine à états indiquant si cette adresse est accessible en lecture seule par tous les processus ou en lecture et écriture par un unique processus en fonction des précédents accès à cette adresse. En fonction de l'état de l'adresse et de l'accès en cours d'instrumentation, ce dernier est autorisé ou le processus est préempté.

Ce mécanisme vise à éviter les violations d'atomicité d'évaluation de processus, également appelés conflits, mais ne garantit pas leur absence. Il est donc nécessaire de contrôler l'absence de conflits à l'issue de chaque phase d'évaluation. Lorsqu'aucun processus n'a été préempté, aucun conflit n'existe, comme cela est détaillé dans la suite de la description. Si un processus est préempté, les accès mémoire susceptibles d'engendrer une dépendance ont par ailleurs été stockés dans une structure dédiée au cours de l'évaluation du quantum. Cette dernière est utilisée par un thread système indépendant pour construire un graphe de dépendances inter-processus et vérifier qu'aucun conflit matérialisé par un cycle dans le graphe n'existe. Cette vérification prend place pendant que la simulation se poursuit. Le noyau de simulation récupère les résultats en parallèle d'une phase d'évaluation ultérieure.

En cas de conflit, un système de retour en arrière permet de revenir à un état passé de la simulation avant le conflit. Lorsqu'une erreur survient, la cause de l'erreur est analysée à l'aide des relations de dépendance entre processus et la simulation est reprise au dernier point de sauvegarde précédant le conflit. L'ordonnancement à appliquer pour éviter une reproduction du conflit est transmis à la simulation avant qu'elle ne reprenne. La simulation reprend par ailleurs en mode "reproduction de simulation", détaillé dans la suite de la description, qui permet de garantir un résultat de simulation identique d'une simulation à la suivante. Cela évite que le point de conflit ne soit déplacé en raison du non déterminisme de la simulation parallèle et que celui-ci survienne à nouveau.

La présente invention permet de détecter les sections de code simulé appartenant au système d'exploitation simulé (code noyau) et d'évaluer ces dernières séquentiellement. Cela garantit qu'aucune dépendance circulaire ne peut se former à cause du code noyau seul. Des dépendances peuvent tout de même se former mais une dépendance circulaire proviendra nécessairement en partie de code hors du noyau.

Le code noyau a la particularité d'être généralement exécuté sous un "niveau de privilège" supérieur. Cela permet au processeur d'effectuer des actions impossibles dans un niveau de privilège inférieur telles que l'accès à des périphériques. Recourir aux fonctionnalités du système d'exploitation est en fait généralement requis pour cette raison précise : l'action intentée nécessite un niveau de privilège supérieur qui oblige à recourir aux services du système d'exploitation.

Généralement il existe plusieurs niveaux ordonnés de privilège, dont le plus bas est nommé le niveau inférieur (par exemple utilisateur) et les plus élevés, dont on détermine le nombre, sont nommés les niveaux supérieurs.

La mise en œuvre est donc la suivante : lorsqu'une élévation du niveau de privilège d'un processeur simulé est détectée 3bis, le processus du processeur correspondant est immédiatement suspendu pour reprendre lors d'une sous-phase séquentielle. Le processus ne sera de nouveau évalué dans une sous-phase parallèle qu'au début de la phase d'évaluation suivant le retour du niveau de privilège au niveau inférieur.

Le niveau de privilège d'un processeur est généralement modélisé au sein d'un simulateur par une simple variable numérique entière dont la valeur correspond directement au niveau de privilège du processeur. Il faut remonter au noyau de simulation les modifications de cette variable afin de suspendre le processus correspondant le cas échéant.

Il est à noter que l'hypothèse selon laquelle les processus n'interagissent que via la mémoire partagée du modèle n'est pas limitante. En effet, le procédé consistant en l'exécution séquentielle des processus simulant des processeurs dans un niveau de privilège élevé, l'ordre des interactions de toute nature est contraint de la même manière et les dépendances circulaires de toutes origines sont prévenues, pourvu que les dépendances proviennent du code noyau.

La reproduction de simulation utilise une trace générée lors d'une simulation passée pour reproduire le même résultat. Cette trace représente en substance un ordre partiel dans lequel les processus doivent être exécutés lors de chaque phase d'évaluation. Elle est stockée dans un fichier ou tout autre moyen de stockage persistant entre deux simulations. On appelle ordre partiel un ordre qui n'est pas total, i.e. un ordre qui ne permet pas de classer l'ensemble des éléments les uns par rapport aux autres. En particulier, les processus entre lesquels aucune relation d'ordre n'est définie sont exécutables en parallèle.

L'invention ne requiert pas de connaître au préalable les adresses partagées ou en lecture seule pour fonctionner, ce qui permet une plus grande souplesse d'utilisation. Les éventuels conflits sont alors gérés par une solution de retour en arrière de simulation. Elle présente également un niveau de parallélisme supérieur aux solutions semblables.

L'invention permet de se prémunir contre un risque important de dépendance circulaire engendrant de fréquents retours en arrière de la simulation, qui augmentent fortement le temps de simulation.

Elle identifie avec fiabilité une source majeure de dépendances circulaires et offre une contremesure efficace. Le mécanisme suspension/reprise des processus est exploité pour évaluer séquentiellement les processus simulant des processeurs dans un niveau de privilège élevé.

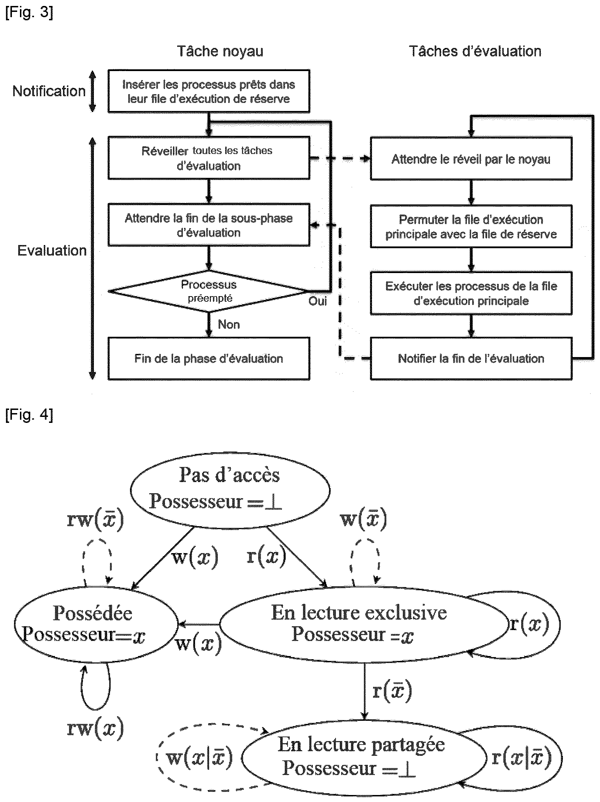

La figure 3 illustre schématiquement l'ordonnancement parallèle de processus, avec l'utilisation de files de processus. En variante, au lieu d'utiliser des files de processus, il est possible d'utiliser une répartition des processus par partage global, c'est-à-dire que chaque tâche d'évaluation exécute un processus en attente prélevé dans la file globale des processus devant être évalués au cours de la phase d'évaluation présente.

Dans la suite de la description, de manière non limitative, l'utilisation de files de processus est plus particulièrement décrite.

L'exécution parallèle d'une simulation à événements discrets repose sur un ordonnancement parallèle de processus. L'ordonnancement proposé dans la présente invention permet d'évaluer les processus concurrents de chaque phase d'évaluation en parallèle. Pour cela, les processus sont attribués à différentes files d'exécution. Les processus de chaque file d'exécution sont alors exécutés tour à tour. Les files d'exécution sont cependant exécutées en parallèle les unes des autres par différentes tâches ("threads" en langue anglaise) système nommées tâches d'évaluation.

Un mode de réalisation offrant les meilleures performances consiste à laisser l'utilisateur associer statiquement chaque processus de la simulation à une file d'exécution et d'associer chaque file d'exécution à un cœur logique de la plateforme de simulation. Il est cependant possible d'effectuer cette distribution automatiquement en début de simulation ou même dynamiquement à l'aide d'algorithme d'équilibrage de charge tel que celui de vol de tâche ou "work stealing" en langue anglaise.

Une file d'exécution peut être implémentée à l'aide de trois files dont l'utilisation détaillée sera décrite dans la suite de la description : la file principale contenant les processus à évaluer pendant la sous-phase d'évaluation en cours, la file de réserve contenant les processus à évaluer lors de la prochaine sous-phase d'évaluation et la file des processus terminés contenant les processus dont l'évaluation est terminée.

L'ordonnancement des tâches est alors effectué de manière distribuée entre le noyau de simulation et les différentes files d'exécution, conformément à la Figure 3, qui disposent tous d'une tâche système dédiée et, de préférence, d'un cœur logique dédié.

La phase d'évaluation débute à l'issue d'une des trois phases de notification possibles (instantanées, deltas ou temporelles). A ce stade, les processus prêts à être exécutés sont placés dans les différentes files d'exécution de réserve de chaque tâche d'évaluation. Le noyau réveille alors toutes les tâches d'évaluation qui entame alors la première sous-phase d'évaluation. Chacune de ces tâches permute sa file de réserve avec sa file principale, et consomme les processus de cette dernière un par un (l'ordre n'a pas d'importance). Un processus peut terminer de deux manières : soit il atteint un appel à la fonction ou clause d'attente ou "wait()" en langue anglaise, soit il est préempté pour cause d'accès mémoire introduisant une dépendance avec un processus d'une autre file d'évaluation.

Dans le premier cas, le processus est retiré de la file d'exécution principale et placé dans la liste des processus terminés. Dans le second cas, il est transféré dans la file d'exécution de réserve. Une fois tous les processus préemptés ou terminés, la première sous-phase d'évaluation parallèle est terminée. Si aucun processus n'a été préempté, la phase d'évaluation est terminée. Si au moins un processus a été préempté, alors une nouvelle sous-phase d'évaluation parallèle est entamée. Toutes les tâches exécutant les files d'exécution sont alors de nouveau réveillées et réitèrent la même procédure. Les sous-phases d'évaluation parallèles se répètent ainsi jusqu'à ce que tous les processus soient terminés (i.e. atteignent un appel à wait()).

L'invention repose sur le contrôle des interactions par accès à de la mémoire partagée produits par l'ensemble des processus évalués en parallèle. L'objectif est de garantir que l'entrelacement des accès mémoire résultant de l'évaluation parallèle des files d'exécution est équivalent à une évaluation atomique des processus. Dans le cas contraire, il y a conflit. Seuls les accès aux adresses partagées peuvent causer des conflits, les autres accès étant indépendants les uns des autres. Afin d'augmenter la flexibilité d'utilisation du noyau SystemC parallèle proposé et de réduire le risque d'erreurs relatives aux déclarations de zones mémoire partagées, l'invention comporte une détection dynamique d'adresses partagées ne nécessitant aucune information préalable de la part de l'utilisateur. Il est ainsi possible de préempter les processus accédant à des zones mémoire partagées et donc risquant d'occasionner des conflits.

La technique présentée ici s'appuie sur l'instrumentation de l'intégralité des accès mémoire. Cette instrumentation est basée sur l'identifiant ID du processus effectuant un accès ainsi que sur la tâche d'évaluation l'exécutant, sur le type d'accès (lecture ou écriture) et sur les adresses accédées. Ces informations sont traitées à l'aide de la machine à états de la figure 4, instanciée une fois par adresse mémoire accessible sur le système simulé. Chaque adresse peut ainsi être dans l'un des quatre états suivants :
- "pas d'accès" (No_acces en langue anglaise), lorsque la machine à états a été réinitialisée, sans processus défini comme possesseur (Owner en langue anglaise) de l'adresse ;
- "possédée" (Owned en langue anglaise) lorsque l'adresse a été accédée par un unique processus dont une fois en écriture, ledit processus étant alors défini comme possesseur (Owner en langue anglaise) de l'adresse ;
- "en lecture exclusive" (Read_exclusive en langue anglaise) lorsque l'adresse a été accédée exclusivement en lecture par un unique processus, ledit processus étant alors défini comme possesseur (Owner en langue anglaise) de l'adresse ; et
- "en lecture partagée" (Read_shared en langue anglaise) lorsque l'adresse a été accédée exclusivement en lecture par au moins deux processus, sans processus défini comme possesseur (Owner en langue anglaise) de l'adresse.

En ce cas, la préemption d'un processus par le noyau est déterminée lorsque :
- un accès en écriture est demandé sur une adresse de la mémoire partagée par un processus qui n'est pas possesseur dans la machine à états de l'adresse, et l'état courant est différent de "pas d'accès" ; ou
- un accès en lecture est demandé sur une adresse de la mémoire partagée, dont la machine à états est dans l'état "possédée" ou " en lecture exclusive" par un processus différent du processus possesseur de l'adresse dans la machine à états de l'adresse.

En variante, chaque adresse peut être dans l'un des quatre états suivants :
- "pas d'accès" (No_acces), lorsque la machine à états a été réinitialisée, sans file de processus définie comme possesseur de l'adresse ;
- " possédée" (Owned) lorsque l'adresse a été accédée par une unique file de processus dont une fois en écriture, ladite file de processus étant alors définie comme possesseur de l'adresse ;
- "en lecture exclusive" (Read_exclusive) lorsque l'adresse a été accédée exclusivement en lecture par une unique file de processus, ladite file de processus étant alors définie comme possesseur de l'adresse ; et
- "en lecture partagée" (Read_shared) lorsque l'adresse a été accédée exclusivement en lecture par au moins deux files de processus, sans file de processus définie comme possesseur de l'adresse.

En ce cas, la préemption d'un processus par le noyau est déterminée lorsque :
- un accès en écriture est demandé sur une adresse de la mémoire partagée par une file de processus qui n'est pas possesseur dans la machine à états de l'adresse, et l'état courant est différent de "pas d'accès" ; ou
- un accès en lecture est demandé sur une adresse de la mémoire partagée, dont la machine à états est dans l'état "possédée" ou " en lecture exclusive" par une file de processus différente de la file de processus possesseur de l'adresse dans la machine à états de l'adresse.

Dans cette machine d'état, les possesseurs sont des tâches d'évaluation (et non des processus SystemC individuels), c'est-à-dire la tâche système en charge d'évaluer les processus listés dans sa file d'évaluation. Cela permet d'éviter que les processus d'une même file d'évaluation ne se bloquent mutuellement alors qu'il est garanti qu'ils ne peuvent s'exécuter simultanément.

Les transitions représentées en traits continus entre les états définissent les accès autorisés lors de la phase d'évaluation parallèle et celles en traits interrompus définissent les accès causant la préemption du processus ; r et w correspondent respectivement à lecture et écriture (pour "read" et "write" en langue anglaise) ; *x* est la première tâche d'évaluation à accéder à l'adresse depuis la dernière réinitialisation ou "reset" en langue anglaise, et *x̅* est n'importe quel autre tâche d'évaluation que *x*.

L'état "possédée" Owned indique que seul le possesseur de l'adresse peut y accéder et l'état "en lecture partagée" Read_shared indique que seules les lectures sont autorisées pour toutes les tâches d'évaluation. L'état "en lecture exclusive" Read_exclusive est important lorsque le premier accès à une adresse après une réinitialisation ou reset de la machine à états est une lecture par une tâche T. Si l'état "en lecture exclusive" Read_exclusive n'était pas présent et qu'une lecture par une tâche T entrainait immédiatement une transition vers l'état "en lecture partagée" Read_shared, T ne pourrait plus écrire sur cette adresse sans être préempté, même si aucun autre processus n'a accédé à cette adresse entre temps. Cela concernerait typiquement toutes les adresses de la pile mémoire des processus exécutés par T et entrainerait donc une préemption quasi systématique de tous les processus de T et de tous les processus des autres tâches de manière identique. Avec l'état "en lecture exclusive" Read_exclusive, il est possible d'attendre une lecture d'un autre thread *x̅* ou bien une écriture de *x* pour décider avec plus de fiabilité de la nature de l'adresse considérée.

Un processus est préempté dès qu'il tente d'effectuer un accès qui rendrait l'adresse partagée autrement que "en lecture seule" depuis la dernière réinitialisation de la machine à états. Cela correspond à une écriture à une adresse par un processus dont la tâche d'évaluation n'est pas le possesseur Owner (sauf si dans l'état "pas d'accès" No_access) ou à un accès en lecture sur une adresse dans l'état "possédée" Owned et dont le possesseur Owner est une autre tâche d'évaluation. Ces règles de préemption garantissent qu'entre deux réinitialisations, il est impossible qu'une tâche d'évaluation lise (respectivement écrive) une adresse préalablement écrite (respectivement écrite ou lue) par une autre tâche d'évaluation. Cela garantit donc l'absence de dépendances liées aux accès mémoire entre les processus de deux files d'évaluation distinctes entre deux réinitialisations.

Afin d'implémenter cette technique, une fonction d'enregistrement des accès mémoires RegisterMemoryAccess() prenant en argument l'adresse d'un accès, sa taille et son type (lecture ou écriture) est mise à disposition de l'utilisateur. Ce dernier doit appeler cette fonction avant chaque accès mémoire. Cette fonction récupère l'identifiant du processus appelant et de sa tâche d'évaluation, et l'instance de la machine à états associée à l'adresse accédée est mise à jour. En fonction de la transition effectuée, le processus peut soit continuer et effectuer l'accès mémoire instrumenté ou être préempté pour poursuivre dans la sous-phase parallèle suivante.

Les machines à états sont stockées dans un conteneur associatif dont les clefs sont des adresses et les valeurs des instances de la machine à états représentée Figure 3. Ce conteneur doit supporter l'accès et la modification concurrente. Cela a été réalisé de deux manières différentes notamment selon la taille de l'espace mémoire simulé. Lorsqu'il est possible d'avoir l'intégralité des machines à états pré-allouées de manière contigüe (e.g. dans un std::vector en C++), cette solution est privilégiée car elle offre des temps minimums d'accès aux machines à états. Cette technique est à privilégier par exemple sur des systèmes utilisant un espace mémoire physique de 32 bits ou moins. Pour des espaces mémoire de taille supérieure, une structure de type table des pages multi-niveaux peut être utilisée (on appelle page un ensemble de taille donnée, comme quelques Mo, contiguë et aligné d'adresses). Cette structure nécessite un nombre supérieur d'indirections (typiquement trois) pour accéder à la machine à états souhaitée mais peut supporter n'importe quelle taille d'espace mémoire avec un coût en mémoire proportionnel au nombre de pages accédées lors de la simulation et un temps d'accès proportionnel à la taille de l'espace mémoire en bits.

Une fois la machine à états de l'adresse accédée récupérée, la transition à effectuer est déterminée à partir de l'état courant et des caractéristiques de l'accès en cours d'instrumentation. La transition doit être calculée et appliquée de manière atomique à l'aide, par exemple, d'une instruction atomique de type compare et échange, "compare and swap" en langue anglaise. Pour que cela soit efficace et ne requiert pas d'espace mémoire additionnel, l'ensemble des champs composant l'état d'une adresse doivent être représentables sur le plus grand nombre de bits manipulables de manière atomique (128 bits sur AMD64), le plus faible étant le mieux. Ces champs sont dans notre cas un octet pour l'état de l'adresse, un octet pour l'identifiant ID de la tâche d'évaluation possesseur de l'adresse et deux octets pour le compteur de réinitialisations, détaillé dans la suite de la description, pour un total de 32 bits. Si la mise à jour atomique de l'état échoue, cela signifie qu'un autre processus a mis à jour la même machine à états simultanément. La fonction de mise à jour de la machine à états est alors rappelée pour tenter une nouvelle fois la mise à jour. Cela se répète jusqu'au succès de la mise à jour de la machine à états. Une optimisation de performance consiste à ne pas effectuer le "compare and swap" atomique si la transition empruntée boucle sur le même état. Cela est possible car les accès causant une transition qui boucle sur un même état sont commutatifs avec tous les autres accès d'une même sous-phase d'évaluation. C'est-à-dire que l'ordre dans lequel ces accès bouclant sur un même état sont enregistrés par rapport aux accès immédiatement voisins dans le temps n'a pas d'influence sur l'état final de la machine à états et ne change pas les processus éventuellement préemptés.

La fonction de mise à jour de la machine à états de l'adresse accédée indique finalement si le processus appelant doit être préempté ou non en retournant par exemple un booléen.

Afin de ne reprendre l'exécution d'un processus qu'une fois les processus dont il dépend terminés, il suffit, lors de la sous-phase d'évaluation suivante, de vérifier si les processus attendus sont terminés. Si tel n'est pas le cas, le processus est préempté de nouveau, sinon il reprend son cours. La liste des processus terminés est construite par le noyau à l'issue de chaque sous-phase d'évaluation dans laquelle au moins un processus a été préempté. A ces fins, le noyau agrège pour cela les listes de processus terminés de chaque tâche d'évaluation.

Les machines à états servent à déterminer la nature des différentes adresses et à autoriser ou non certains accès en fonction de l'état de ces adresses. Cependant, dans une application, certaines adresses peuvent changer d'usage. Par exemple, une mémoire tampon, ou "buffer" en langue anglaise, peut être utilisée pour y stocker une image qui est ensuite traitée par plusieurs threads par la suite. Lors de l'initialisation de la mémoire tampon, il est courant qu'une unique tâche n'accède à cette mémoire. Le processus SystemC simulant cette tâche est alors possesseur des adresses contenues dans la mémoire tampon. Cependant, lors de la phase de traitement de l'image, de multiples processus accèdent à cette image en parallèle. Si le résultat du traitement de l'image n'est pas placé directement dans la mémoire tampon, ce dernier devrait alors être intégralement dans l'état "en lecture partagée" Read_shared. Or, il est impossible de passer de l'état "possédée" Owned à l'état "en lecture partagée" read_shared sans procéder d'abord à une réinitialisation de la machine à états, c'est-à-dire un retour forcé dans l'état "pas d'accès" No_access.

Les performances sont alors largement impactées par la politique de réinitialisation adoptée (quand et quelles machines à états réinitialiser), ainsi que par l'implémentation de ce mécanisme de réinitialisation. Un mode de réalisation de la politique de réinitialisation est le suivant, mais d'autres peuvent être mises en œuvre : lorsqu'un processus accède à une adresse partagée et qu'il se trouve préempté, l'intégralité des machines à états sont réinitialisées lors de la prochaine sous-phase d'évaluation parallèle. Cela se justifie par l'observation suivante : souvent, un accès à une adresse partagée est symptomatique de la situation décrite ci-dessus, c'est-à-dire qu'un ensemble d'adresses d'abord accédées par un processus donné sont ensuite uniquement lues par un ensemble de processus ou accédées par un autre processus exclusivement (on peut dire que les données migrent d'une tâche à une autre). Les machines à états de ces adresses doivent alors être réinitialisées pour rejoindre nouvel état plus adapté. Il est cependant difficile d'anticiper quelles sont exactement les adresses qui doivent changer d'état. L'option retenue est donc de réinitialiser l'intégralité de l'espace d'adresses en s'appuyant sur le fait que les adresses qui n'avaient pas besoin d'être réinitialisées regagneront rapidement leur état précédent.

L'implémentation de cette réinitialisation fait intervenir un compteur *C* stocké avec la machine à états de chaque adresse. Lors de chaque mise à jour de la machine à états, la valeur d'un compteur global *C_{g}* externe à la machine à états est passé en argument supplémentaire. Si la valeur de *C_{g}* diffère de celle de *C*, la machine à états doit être réinitialisée avant d'effectuer la transition et *C* est mis à jour à la valeur *C_{g}*. Ainsi, pour déclencher la réinitialisation de l'intégralité des machines à états, il suffit d'incrémenter *C_{g}*. Le compteur *C* doit être mis à jour avec l'état de la machine à états et l'éventuel possesseur de l'adresse de manière atomique.

Dans le cas décrit précédemment, *C* utilise deux octets. Cela signifie que si *C_{g}* est incrémenté exactement 65 536 fois entre deux accès à une adresse donnée, *C* et *C_{g}* restent égaux et la réinitialisation n'a pas lieu, ce qui entraine potentiellement et très rarement des préemptions inutiles mais ne compromet pas la validité de la technique.

Cette technique de réinitialisation permet de ne pas devoir effectuer une réinitialisation de l'ensemble des machines à états accédées entre deux phases d'évaluation par exemple. Cela entrainerait un ralentissement très important. Dans la solution proposée, ce sont les tâches d'évaluation qui effectuent la réinitialisation au besoin lorsqu'ils accèdent à une adresse.

Concernant la vérification a posteriori des conflits, comme expliqué précédemment, aucune dépendance entre des processus appartenant à des files d'exécution distinctes ne peut être introduite entre deux réinitialisations des machines à états, car tout processus tentant un accès mémoire qui introduirait une telle dépendance est préempté avant de pouvoir effectuer son accès. Si aucun processus n'a été préempté à l'issue de la première sous-phase d'évaluation parallèle, cela signifie qu'aucune dépendance n'existe entre les files d'exécution. Or, les processus d'une même file d'exécution sont évalués successivement, prévenant de l'apparition d'une dépendance circulaire entre eux au sein d'une sous-phase d'évaluation donnée. Par conséquent, aucune dépendance circulaire n'existe entre l'ensemble des processus et donc aucun conflit. Aucune vérification supplémentaire n'est donc requise si une phase d'évaluation n'est composée que d'une unique sous-phase d'évaluation. Dans la pratique, la majorité des phases d'évaluation ne nécessitent qu'une seule sous-phase et sont donc immédiatement garanties sans conflit. Cette spécificité de l'invention est l'un de ses plus grands facteurs d'accélération.

Cependant, si des processus ont été préemptés au cours de la première sous-phase d'évaluation parallèle, plusieurs sous-phases d'évaluation parallèle ont lieu et des dépendances peuvent apparaître avec le risque d'un conflit. Il est par conséquent nécessaire de vérifier l'absence de conflits à l'issue de la phase d'évaluation complète dans ces cas. Cette vérification est faite a posteriori, c'est-à-dire que les dépendances entre les processus ne sont pas établies au cours de la phase d'évaluation mais une fois celle-ci terminée et par exemple de manière asynchrone. Pour ce faire, une structure d'enregistrement d'accès, "AccessRecord" en langue anglaise, contenant l'ensemble des accès mémoire effectués durant une phase d'évaluation est utilisée. Cette structure permet le stockage concurrent des accès effectués lors de chaque sous-phase d'évaluation parallèle.

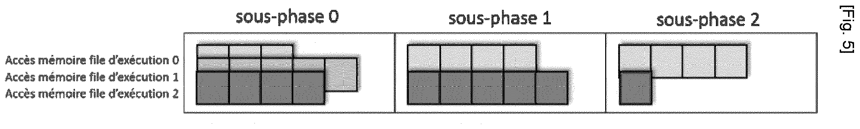

Grâce à la garantie d'absence de dépendance lors de chaque sous-phase d'évaluation parallèle, l'ordre entre les files d'exécution des accès enregistrés pendant chaque sous-phase n'a pas d'importance. Ces accès peuvent donc être enregistrés en parallèle dans plusieurs structures indépendantes. La structure d'enregistrement "AccessRecord" est donc composée pour chaque sous-phase d'un vecteur par file d'exécution comme représenté sur la figure 5. Toute structure de données ordonnée peut être utilisée à la place du vecteur. A la fin de l'appel à fonction d'accès à un registre mémoire "RegisterMemoryAccess()", si le processus appelant n'est pas préempté, il insert dans le vecteur de sa file d'exécution les caractéristiques de l'accès mémoire instrumenté : adresse, nombre d'octets accédés, type d'accès et ID du processus.

A la fin de chaque phase d'évaluation, si plusieurs sous-phases ont eu lieu, le noyau de simulation confie la vérification de l'absence de conflit à une tâche système dédiée. Afin de ne pas devoir créer systématique une nouvelle tâche sans attendre que la vérification d'une phase d'évaluation antérieure se termine, un groupement, ou "pool" en langue anglaise, de tâches est utilisé. Si aucune tâche n'est disponible, une nouvelle tâche y est ajoutée. La vérification de la phase d'évaluation est alors effectuée de manière asynchrone pendant que la simulation continue. Une autre structure d'enregistrement d'accès "AccessRecord", elle-même issue d'un groupement, est utilisée pour la phase d'évaluation suivante.

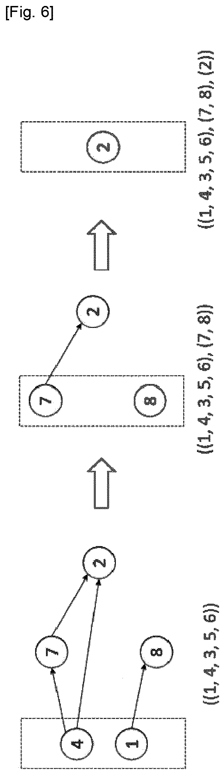

La tâche de vérification énumère alors les accès contenus dans la structure d'enregistrement d'accès "AccessRecord" de la première à la dernière sous-phase d'évaluation. Les vecteurs de chaque sous-phase de la structure d'enregistrement d'accès "AccessRecord" doivent être traités l'un après l'autre dans n'importe quel ordre. Une lecture à une adresse donnée introduit une dépendance avec le dernier écrivain de cette adresse et une écriture introduit une dépendance avec le précédent écrivain et tous les lecteurs depuis ce dernier. Cette règle ne s'applique pas lorsqu'une dépendance concerne un processus avec lui-même. Un graphe de dépendances inter-processus est ainsi construit. Une fois le graphe complété, ce dernier a pour sommets l'ensemble des processus impliqués dans une dépendance qui sont elles-mêmes représentées par des arcs orientés. Une recherche de cycles est alors faite dans le graphe afin de détecter une éventuelle dépendance circulaire entre processus symptomatique d'un conflit. Si aucun cycle, et donc aucun conflit, n'est présent, alors une liste d'ensembles de processus est produite d'après leur niveau dans le graphe de dépendance : les nœuds n'ayant aucun prédécesseur sont groupés avec les processus ne figurant pas dans le graphe ; les autres nœuds sont groupés de manière à ce qu'aucune dépendance n'existe dans chaque groupe et que les groupes soient de taille maximale. Un algorithme est illustré sur la figure 6 avec huit processus comprenant les étapes suivantes :
- étape 1 : grouper les processus sans prédécesseur et ceux ne figurant pas dans le graphe ;
- étape 2 : retirer du graphe les processus déjà groupés ;
- étape 3 : s'il reste des processus, grouper les processus sans prédécesseur, sinon terminer.
- étape 4 : reprendre à l'étape 2.

C'est cette liste de groupes de processus qui est utilisée dans la reproduction de simulation décrite dans la suite de la description.

La récupération du résultat d'une vérification des conflits est effectuée par le noyau de simulation en parallèle d'une phase d'évaluation ultérieure. Une fois que ce dernier a réveillé les tâches d'évaluation, il teste si des résultats de vérification sont prêts avant d'attendre la fin de la sous-phase d'évaluation en cours. Si au moins un résultat de vérification est prêt, le noyau récupère une structure indiquant la phase vérifiée, s'il y a eu un conflit et, en l'absence de conflit, la liste de groupes de processus décrite ci-dessus. Cette liste pourra alors être utilisée pour reproduire la simulation en cours à l'identique ultérieurement. Une optimisation de performance consiste à réutiliser la structure d'enregistrement d'accès "AccessRecord" venant d'être vérifiée dans une phase d'évaluation ultérieure. Cela permet de conserver les mémoires tampons des vecteurs sous-jacents. Si ces derniers devaient être réalloués à chaque phase d'évaluation, les performances seraient réduites.

L'instrumentation des accès mémoire à l'aide de la fonction d'enregistrement d'accès mémoire "RegisterMemoryAccess()" vise, d'une part, à éviter l'apparition de conflits et, d'autre part, à vérifier a posteriori que les accès effectués lors d'une phase d'évaluation donnée correspondent en effet à une exécution sans conflit. Afin que cette vérification soit fiable, il est nécessaire que l'ordre dans lequel les accès sont enregistrés dans une structure d'enregistrement d'accès "AccessRecord" corresponde effectivement à l'ordre des accès réellement effectués. Considérons l'exemple de deux processus P0 et P1 effectuant tous deux un accès à une adresse A. Ces écritures doivent être précédées d'un appel à la fonction d'enregistrement d'accès mémoire "RegisterMemoryAccess()" avant d'être appliquées en mémoire. P0 et P1 s'exécutant en parallèle, l'ordre observé des appels à la fonction d'enregistrement d'accès mémoire "RegisterMemoryAccess()" peut différer de l'ordre observé des écritures qui s'en suivent. Cette inversion d'ordre pourrait invalider totalement la validité de la méthode exposée : si l'ordre enregistré de deux écritures est inversé par rapport à l'ordre réel des écritures, alors la dépendance enregistrée est inversée par rapport à la dépendance réelle et des conflits pourraient passer inaperçus.

Une méthode simple permettant de se prémunir de ce problème consiste à grouper chaque accès mémoire et l'appel à la fonction d'enregistrement d'accès mémoire "registerMemoryAccess()" qui le précède dans une section protégée par une exclusion mutuelle ou "mutex" pour diminutif de "Mutual Exclusion" en langue anglaise. Cette solution est fonctionnellement correcte mais ralentit drastiquement la simulation. Au contraire, une propriété cruciale de l'invention dispense totalement de synchronisation. En effet, comme expliqué ci-dessus, tout accès mémoire engendrant une dépendance donne lieu à la préemption du processus responsable avant qu'il ne puisse effectuer cet accès. Par conséquent, aucune dépendance ne peut apparaître entre deux processus appartenant à des files d'exécutions distinctes. En particulier, il est impossible que deux accès engendrant une dépendance aient lieu dans la même sous-phase d'évaluation et donc qu'une relation de dépendance soit inversée.

Concernant la récupération des conflits, lorsque la vérification des conflits indique qu'un conflit s'est produit, la simulation n'est plus respectueuse du standard SystemC à compter de la phase d'évaluation ayant un conflit. L'invention repose sur un système de retour en arrière pour rétablir la simulation dans un état valide antérieur.

Tout procédé de retour en arrière pourrait être employé. Le mode de réalisation présenté ici repose sur une technique de retour en arrière au niveau processus système. L'outil CRIU (acronyme de "Checkpoint/Restore In Userspace") disponible sur Linux peut être employé. Il permet d'écrire dans des fichiers l'état d'un processus complet à un instant donné. Cela inclut en particulier une image de l'espace mémoire du processus ainsi que l'état des registres processeur utiles au moment de la sauvegarde. Il est alors possible à partir de ces fichiers de relancer le processus sauvegardé depuis le point de sauvegarde. CRIU permet également d'effectuer des sauvegardes incrémentales de processus. Cela consiste à n'écrire sur le disque que les pages mémoire qui ont changé depuis la dernière sauvegarde et présentent un gain de vitesse conséquent. CRIU peut être contrôlé via une interface RPC basée sur la librairie Protobuf.

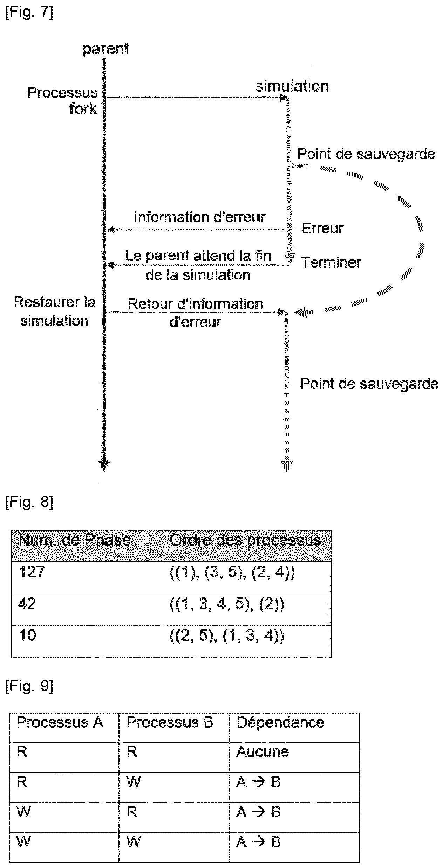

Le principe général du système de retour en arrière est représenté schématiquement sur la figure 7. Au lancement de la simulation, le processus de la simulation est immédiatement dupliqué à l'aide de l'appel système *fork(2).* Il est impératif que cette duplication survienne avant la création de tâches supplémentaires car ces dernières ne sont pas dupliquées par l'appel à *fork(2).* Le processus enfant obtenu sera appelé la simulation et c'est lui qui effectue I simulation à proprement parler. Au cours de la simulation, des points de sauvegarde se succèdent jusqu'à rencontrer éventuellement une erreur qui correspond à un conflit. Dans ce cas, le processus simulation transmet au processus parent les informations relatives à ce conflit, notamment le numéro de la phase d'évaluation dans laquelle le conflit s'est produit et les informations utiles à la reproduction de la simulation jusqu'au point de conflit, comme décrit dans la suite de la description. L'ordre d'exécution à appliquer afin d'éviter le conflit peut alors être transmis. Celui-ci est obtenu en supprimant un arc par boucle dans le graphe de dépendance de la phase ayant causé le conflit et en appliquant l'algorithme de génération de la liste de groupes de processus. Le processus parent attend alors que le processus simulation se termine avant de le relancer à l'aide de CRIU. Une fois le processus simulation rétabli dans un état antérieur à l'erreur, le processus parent retourne au processus simulation les informations relatives au conflit qui a causé le retour en arrière. La simulation peut alors reprendre et le conflit être évité. Une fois la phase d'évaluation conflictuelle passée, une nouvelle sauvegarde est effectuée.

L'efficacité de l'invention repose sur une politique de sauvegarde adaptée. L'espacement des sauvegardes doit en effet être choisi de manière à en limiter le nombre au maximum tout en évitant qu'un éventuel retour en arrière ne renvoie à une sauvegarde trop ancienne. La première politique de sauvegarde consiste à ne sauvegarder qu'au tout début de la simulation et d'attendre ensuite le premier conflit, s'il survient. Cela est très bien adapté aux simulations ne causant pas ou peu de conflits. Une autre politique consiste à sauvegarder la simulation à intervalles réguliers, par exemple toutes les 1000 phases d'évaluation. Il est aussi possible de faire varier cet intervalle de sauvegarde en l'augmentant en l'absence de conflit et en le réduisant suite à un conflit par exemple. Lorsqu'un point de sauvegarde est atteint, le noyau de simulation commence par attendre que toutes les vérifications de conflits des phases d'évaluation précédentes soient terminées. Si aucun conflit n'est survenu, une nouvelle sauvegarde est effectuée.

Concernant la reproduction d'une simulation, le noyau de simulation SystemC proposé peut fonctionner en mode reproduction de simulation. Ce mode de fonctionnement utilise une trace générée par la simulation à reproduire. Cette trace permet alors de contrôler l'exécution des processus afin de garantir un résultat de simulation identique à la simulation ayant produit la trace, respectant ainsi les exigences du standard SystemC. La trace utilisée par l'invention est composée de la liste des numéros des phases d'évaluation pendant lesquelles des dépendances entre processus sont apparues, auxquels sont associés les ordres dans lequel ces processus doivent être exécutés lors de chacune de ces phases d'évaluation pour reproduire la simulation. Un exemple est donné dans le tableau de la figure 8, dans lequel, pour chaque phase listée, chaque groupe de processus (parenthèses intérieures) est exécutable en parallèle mais les groupes doivent être exécutés dans des sous-phases séquentielles distinctes. Cette trace est stockée dans un fichier (par exemple par sérialisation) entre deux simulations ou tout autre moyen de stockage persistant suite à la fin du processus de simulation.

La reproduction de simulation utilise deux conteneurs : l'un, nommé Tw (pour "Trace write" en langue anglaise), servant à stocker la trace de la simulation en cours, l'autre, nommé Tr (pour "Trace read" en langue anglaise), contenant la trace d'une simulation précédente passée en paramètre de la simulation si la reproduction de simulation est activée. Un nouvel élément est inséré dans Tw à l'issue de chaque fin de vérification des conflits. Tw est sérialisé dans un fichier à la fin de chaque simulation.

Si la reproduction de simulation est activée, Tr est initialisé en début de simulation à l'aide de la trace d'une simulation passée en argument du programme. Au début de chaque phase d'évaluation, il est alors vérifié si son numéro figure parmi les éléments de Tr. Si tel est le cas, la liste associée à ce numéro de phase dans Tr est utilisée pour ordonnancer la phase d'évaluation. Pour cela, la liste des processus à exécuter dans la prochaine sous-phase d'évaluation parallèle est passée aux threads d'évaluation. A leur réveil, ces derniers vérifient avant de commencer l'évaluation de chaque processus que ce dernier figure dans la liste. Dans le cas contraire, le processus est immédiatement placé dans la file d'exécution de réserve pour être évalué ultérieurement.

Tr peut être implémenté à l'aide d'un conteneur associatif avec les numéros de phase d'évaluation en guise de clé mais il est plus efficace d'utiliser un conteneur séquentiel du type vecteur dans lequel les paires ou couples (numéro de phase; ordre des processus) sont stockées dans l'ordre décroissant des numéros de phase d'évaluation (chaque ligne du tableau de la figure 8 est une paire du vecteur). Afin de vérifier si la phase d'évaluation en cours est présente dans Tr, il suffit alors de comparer son numéro au dernier élément de Tr et, s'ils sont égaux, de supprimer ce dernier de Tr à l'issue de la phase d'évaluation.

Si le mode reproduction de simulation n'est pas activé, des conflits peuvent survenir suivis d'un retour en arrière de la simulation. Le mode reproduction de simulation entre le point de retour et le point où le conflit est survenu est alors activé. Cela évite qu'un conflit différent ne survienne suite au retour en arrière en raison du non déterminisme de la simulation. Tw est alors transmis via le système de retour en arrière afin d'initialiser Tr. En plus d'être triés, les éléments correspondant à des phases d'évaluation antérieures au point de retour doivent être supprimés de Tr. La reproduction de simulation peut être désactivée une fois le point de conflit dépassé.

Une optimisation de performance consiste à désactiver les systèmes de détection des adresses partagées et de vérification des conflits lorsque la reproduction de simulation est activée. En effet, ce dernier garantit que la nouvelle instance de la simulation fournit un résultat identique à la simulation reproduite. Or, la trace obtenue à l'issue de cette dernière permet d'éviter tous les conflits qui pourraient survenir. Dans le cas d'un retour en arrière, il est cependant important de désactiver le mode reproduction de simulation après le point de conflit si cette optimisation est utilisée.

Il est supposé que chacun des processeurs d'un modèle SystemC est simulé par un processus SystemC. A chaque phase d'évaluation, chacun des processus simule un certain nombre d'instructions jusqu'à ce que le "quantum" de temps soit consommé. Le "quantum" de temps décrit le temps simulé pendant lequel un processus est autorisé à poursuivre sans passer la main au processus suivant. L'utilisation d'un quantum de temps permet à un processus de simuler un plus grand nombre d'actions à la fois, réduisant le nombre de changements de contexte et accélérant ainsi la simulation. On parle alors de découplage temporel. Dans une simulation à événements discret classique utilisant le découplage temporel, les processus sont donc évalués les uns après les autres et chaque processus simule de quelques dizaines à plusieurs milliers d'instructions à la fois avant de passer la main au processus suivant. Si les processus sont en revanche évalués en parallèle comme comme dans la présente invention, il est requis par le standard SystemC que leur évaluation soit équivalente à une évaluation séquentielle. Cela est conditionné par les interactions survenant lors de leur évaluation et de l'ordre de ces interactions.

On suppose que les différents processus d'une simulation SystemC n'interagissent qu'au travers d'accès à la mémoire partagée du modèle simulé. Par exemple si, au cours d'une même phase d'évaluation, deux processus n'accèdent qu'à des adresses mémoires que l'autre processus n'accède pas, il n'y a pas d'interaction entre ces processus qui sont alors indépendants. Ils peuvent donc être évalués en parallèle sans risquer de violation d'atomicité.

A l'inverse, si deux processus accèdent à une même adresse au cours d'une phase d'évaluation et qu'au moins un de ces accès est une écriture, l'un de ces deux processus devient dépendant de l'autre. La notion de dépendance est à comprendre ici au sens de contrainte sur l'ordre d'évaluation séquentiel équivalent des processus. La question est en effet de déterminer, lors de l'évaluation parallèle des processus, s'il existe un ordre d'évaluation séquentielle générant les mêmes interactions entre processus et dans le même ordre II s'agit d'une condition nécessaire et suffisante au respect de la "sémantique de coroutines" imposée par le standard SystemC. On dit alors, à l'issue d'une évaluation parallèle, qu'un processus A dépend d'un processus B si et seulement si une évaluation séquentielle équivalente doit évaluer B avant A.

La figure 9 illustre les accès mémoire pouvant introduire une dépendance au sens précédemment décrit. Dans le tableau de la figure 9, deux processus A et B sont supposés accéder une même adresse mémoire. Le premier est A et le second est B. R désigne une lecture (pour "Read" en langue anglaise) et W une écriture (pour "Write" en langue anglaise). A → B décrit le fait que B dépend de A et donc qu'une évaluation séquentielle équivalente doit évaluer A avant B afin de préserver l'ordre des accès mémoire à l'adresse considérée.

Supposons maintenant qu'A et B accèdent deux adresses en commun mais que l'ordre d'accès ne soit pas le même pour les deux adresses. Les dépendances A→B et B→A sont alors formées. Il n'existe alors plus d'évaluation séquentielle équivalente puisqu'A et B doivent se succéder l'un l'autre. On parle ici de dépendance circulaire A→B→A synonyme de violation d'atomicité des processus et donc d'erreur de simulation nécessitant un retour en arrière. Une dépendance circulaire peut impliquer un nombre arbitraire de processus tel que A→B→C→D→A.

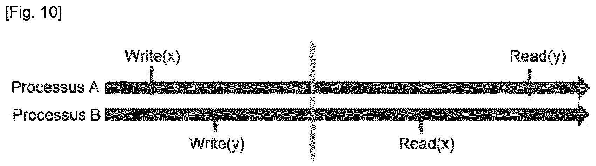

Pour chaque accès à la mémoire simulée tenté par un processus, la présente invention détermine si cet accès mémoire peut avoir lieu immédiatement ou si le processus doit être suspendu. On détermine alors quand le processus pourra reprendre son évaluation. Indépendamment des cas de figure entrainant la suspension d'un processus et indépendamment de l'instant auquel ce processus reprend son évaluation, il existe des situations générant une violation d'atomicité et qu'il est virtuellement impossible de prévenir. Un tel exemple est illustré sur la figure 10.

Sur la figure 10, on suppose que x et y sont deux adresses mémoire jamais accédées par aucun des processus par le passé. Il s'agit donc d'adresses parfaitement banales et rien ne permet, sans une connaissance extrêmement fine du logiciel simulé, de les considérer comme susceptibles de causer une dépendance circulaire. Elles sont comme n'importe quelles adresses accédées pour la première fois via une écriture afin d'être initialisées ; un scénario extrêmement banal en informatique. Au niveau de l'instant représenté par la séparation verticale, il n'existe aucune raison de ne pas laisser les processus A et B poursuivre en parallèle.

Le logiciel simulé va cependant provoquer lors de cette même phase d'évaluation des lectures croisées sur ces mêmes adresses après la séparation verticale. Les dépendances A→B puis B→A vont alors se former, créant une dépendance circulaire et donc nécessitant un retour en arrière relativement coûteux en termes de vitesse de simulation. Le problème vient du fait que jusqu'à l'instant représenté par la séparation verticale, rien ne permettait d'anticiper ce qui allait suivre. Dans le même temps, quel que soit l'ordre d'évaluation de A et B après la séparation verticale, une dépendance circulaire se forme et l'erreur est donc inévitable (sauf avec une connaissance de l'application permettant de prévoir que ces adresses seront partagées).

Ce type de scénario se produit en général lors de la simulation de code dit sans verrous ou "lockless" en langue anglaise. Il s'agit d'une technique de programmation ayant recours à des instructions processeur dites atomiques. Ces instructions autorisent plusieurs processeurs à manipuler simultanément la même adresse mémoire sans engendrer d'incohérence sur la valeur finale stockée à cette adresse. Il est par exemple possible d'incrémenter la valeur stockée à une adresse donnée ou de tester cette valeur et de la remplacer si sa valeur est égale à une certaine autre valeur, le tout de manière atomique, c'est-à-dire sans qu'un autre processeur puisse intervenir sur l'adresse en cours d'opération. Le recours à ce type d'instruction procure des propriétés particulières à un logiciel, propriétés souvent recherchées dans le contexte d'un système d'exploitation : support d'un grand nombre de fils d'exécution partageant de nombreuses ressources (mémoire, système de fichiers, etc.) tout en préservant un excellent niveau de performances dans la plupart des circonstances.

Les techniques de programmation sans verrous sont en revanche extrêmement complexes et difficiles à exploiter sans bogues, limitant leur utilisation à quelques logiciels spécifiques pour lesquels les performances ne peuvent être sacrifiées au profit de la simplicité du code. La présente invention se concentre sur la prévention des dépendances circulaires lors de la simulation de code sans verrou présent dans le noyau d'un système d'exploitation. En particulier, l'invention n'aide pas à la gestion du code sans verrou présent dans les programmes exécutés sous un système d'exploitation mais uniquement à la gestion du code appartenant au système d'exploitation lui-même.

### [Bibliographie]

### | BIBLIOGRAPHIE

SCHM18 T. Schmidt, Z. Cheng, and R. Dömer, "Port call path sensitive conflict analysis for instance-aware parallel SystemC simulation," in DATE 2018
SCHU10 C. Schumacher, R. Leupers, D. Petras, and A. Hoffmann, "parSC : Synchronous parallel SystemC simulation on multi-core host architectures," in CODES+ISSS 2010
MELL10 A. Mello, I. Maia, A. Greiner, F. Pecheux, I. M. aind A. Greiner, and F. Pecheux, "Parallel Simulation of SystemC TLM 2.0 Compliant MPSoC on SMP Workstations," in DATE 2010
WEIN16 J. H. Weinstock, R. Leupers, G. Ascheid, D. Petras, and A. Hoffmann, "SystemC-Link : Parallel SystemC Simulation using Time-Decoupled Segments," in DATE 2016
SCHU13 C. Schumacher et al., "legaSCi: Legacy SystemC Model Intégration into Parallel Système Simulators," in IPDPSW 2013.
MOY13 M. Moy, "Parallel programming with SystemC for loosely timed models: A non-intrusive approach," in DATE 2013
VENT16 N. Ventroux and T. Sassolas, "A new parallel SystemC kernel leveraging manycore architectures," in DATE 2016
LE14 H. M. Le and R. Drechsler, "Towards verifying determinism of SystemC designs," in DATE 2014
JUNG19 M. Jung, F. Schnicke, M. Damm, T. Kuhn, and N. Wehn, "Speculative Temporal Decoupling Using fork()," in DATE 2019

## Revendications

1. Procédé de simulation à événements discrets parallèle reproductible de niveau système électronique mis en œuvre au moyen d'un système informatique multi-cœurs, ledit procédé de simulation comprenant une succession de phases d'évaluation, mises en œuvre par un noyau de simulation exécuté par ledit système informatique, comprenant les étapes suivantes :
- ordonnancement parallèle de processus (1) ;
- détection dynamique d'adresses partagées (2) d'au moins une mémoire partagée d'un système électronique simulé par des processus concurrents, à des adresses de la mémoire partagée, utilisant une machine à états, respectivement associée à chaque adresse de la mémoire partagée ;
- évitement de conflits d'accès (3) à des adresses de la mémoire partagée par des processus concurrents, par préemption d'un processus par le noyau lorsque ledit processus introduit une dépendance inter-processus de type "lecture après écriture" ou "écriture après lecture ou écriture" ou lorsque le processus simule un processeur dont le niveau de privilège (3bis) passe du niveau inférieur à un niveau supérieur ;
- vérification de conflits d'accès (4) à des adresses de mémoire partagée par analyse des dépendances inter-processus utilisant une trace des accès aux adresses de mémoire partagée de chaque phase d'évaluation et une recherche de cycles dans un graphe de dépendances inter-processus ;
- retour en arrière (5), lors d'une détection d'au moins un conflit, pour rétablir un état passé de la simulation après détermination d'un ordre d'exécution sans conflit des processus de la phase d'évaluation conflictuelle durant laquelle est détectée le conflit, lors d'une nouvelle simulation identique jusqu'à la phase d'évaluation conflictuelle exclue ; et
- génération d'une trace d'exécution (6) permettant la reproduction ultérieure de la simulation à l'identique.

2. Procédé selon la revendication 1, dans lequel l'ordonnancement parallèle de processus (1) utilise des files d'au moins un processus, les processus d'une même file étant exécutés séquentiellement par une tâche système associée à un cœur logique.

3. Procédé selon l'une des revendications précédentes, dans lequel la reprise de l'exécution d'une file d'au moins un processus, dont l'exécution a été suspendue suite à la préemption d'un de ses processus par le noyau, est effectuée dans une sous-phase parallèle ultérieure si la préemption est due à l'introduction par ledit processus d'une dépendance inter-processus de type "lecture après écriture" ou "écriture après lecture ou écriture", ou est effectuée dans une sous-phase séquentielle ultérieure si la préemption est due au passage du cœur logique exécutant le processus d'un niveau de privilège inférieur à un niveau de privilège supérieur.

4. Procédé selon l'une des revendications précédentes, dans lequel le retour en arrière (5) utilise des sauvegardes d'états de la simulation durant la simulation faites par le noyau de simulation.

5. Procédé selon l'une des revendications 1 à 3, dans lequel la machine à états d'une adresse de la mémoire partagée comprend les quatre états suivants :
- "pas d'accès" (No_acces), lorsque la machine à états a été réinitialisée, sans file d'au moins un processus définie comme possesseur de l'adresse ;
- "possédée" (Owned) lorsque l'adresse a été accédée par une unique file d'au moins un processus dont une fois en écriture, ladite file étant alors définie comme possesseur de l'adresse ;
- "en lecture exclusive" (Read_exclusive) lorsque l'adresse a été accédée exclusivement en lecture par une unique file d'au moins un processus, ladite file étant alors définie comme possesseur de l'adresse ; et
- "en lecture partagée" (Read_shared) lorsque l'adresse a été accédée exclusivement en lecture par au moins deux files d'au moins un processus, sans file définie comme possesseur de l'adresse.

6. Procédé selon la revendication 5, dans lequel la préemption d'un processus (3) par le noyau est déterminée lorsque :
- un accès en écriture est demandé sur une adresse de la mémoire partagée par une file d'au moins un processus qui n'est pas possesseur dans la machine à états de l'adresse, et l'état courant est différent de "pas d'accès" ; ou
- un accès en lecture est demandé sur une adresse de la mémoire partagée, dont la machine à états est dans l'état "possédée" ou " en lecture exclusive" par une file d'au moins un processus différente de la file possesseur de l'adresse dans la machine à états de l'adresse.

7. Procédé selon l'une des revendications 5 ou 6, dans lequel toutes les machines à états des adresses de la mémoire partagée sont réinitialisées à l'état "pas d'accès" régulièrement.

8. Procédé selon l'une des revendications 5 ou 6, dans lequel toutes les machines à états des adresses de la mémoire partagée sont réinitialisées à l'état "pas d'accès " lors de la phase d'évaluation suivant la préemption d'un processus.

9. Procédé selon l'une des revendications précédentes, dans lequel la vérification de conflits d'accès (4) à des adresses de mémoire partagée lors de chaque phase d'évaluation est effectuée de manière asynchrone, pendant l'exécution des phases d'évaluation ultérieures.

10. Procédé selon l'une des revendications précédentes, dans lequel la trace d'exécution (6) permettant la reproduction ultérieure de la simulation à l'identique comprend une liste de numéros représentatifs de phases d'évaluation associés à un ordre partiel d'évaluation des processus définis par les relations de dépendances inter-processus de chaque phase d'évaluation.

11. Procédé, selon l'une des revendications précédentes, dans lequel un retour en arrière (5), lors d'une détection d'au moins un conflit, rétablit un état passé de la simulation, puis reproduit la simulation à l'identique jusqu'à la phase d'évaluation ayant produit le conflit et exécute alors séquentiellement ses processus.

12. Procédé, selon l'une des revendications 1 à 11, dans lequel un retour en arrière (5), lors d'une détection d'au moins un conflit, rétablit un état passé de la simulation, puis reproduit la simulation à l'identique jusqu'à la phase d'évaluation ayant produit le conflit et exécute alors ses processus d'après un ordre partiel déduit du graphe de dépendance de la phase d'évaluation ayant produit le conflit après en avoir supprimé un arc par cycle.

13. Procédé selon l'une des revendications précédentes, dans lequel un état de la simulation est sauvegardé à intervalles réguliers de phases d'évaluation.

14. Procédé selon l'une des revendications 1 à 12, dans lequel un état de la simulation est sauvegardé à intervalles de phases d'évaluation augmentant en l'absence de détection de conflit et en diminuant suite à détection de conflit.

15. Produit programme d'ordinateur comprenant des instructions de code de programme enregistrées sur un support lisible par un ordinateur, pour mettre en œuvre des étapes du procédé selon les revendications 1 à 14 lorsque ledit programme est exécuté sur un ordinateur.
